# EUROPEAN PATENT SPECIFICATION

(11) **EP 1 913 624 B1**
(45) Date of publication and mention of the grant of the patent: **10.08.2011**
(21) Application number: 06785376.2
(22) Date of filing: 21.06.2006
(51) Int. Cl.: H01J 37/34, C23C 14/34, C23C 14/50

(54) **SPUTTERING TARGET WITH SLOW-SPUTTER LAYER UNDER TARGET MATERIAL**
SPUTTER-TARGET MIT LANGSAMSPUTTER-SCHICHT UNTER TARGETMATERIAL
CIBLE DE PULVERISATION CATHODIQUE A COUCHE DE PULVERISATION LENTE SOUS LE MATERIAU CIBLE

(30) Priority: 22.06.2005 US 158407
(43) Date of publication of application: 23.04.2008
(73) Proprietor: Guardian Industries Corp., Auburn Hills, MI 48326-1714 (US)
(72) Inventor: MAYER, Raymond M., Canton, MI 48188 (US); LU, Yiwei, Ann Arbor, MI 48105 (US)
(74) Representative: Hess, Peter K. G.
(86) International application number: PCT/US2006/024371
(87) International publication number: WO 2007/002330

(56) References cited:
- EP-A1- 1 321 537
- WO-A2-02/27057
- JP-A- 5 086 462
- US-A1- 2004 020 769
- US-A1- 2004 115 362
- US-A1- 2005 051 422

## Description

This invention relates to a target for use in sputtering (e.g., magnetron sputtering). In certain example embodiments, the cathode tube of the target is coated with a slow sputtering material prior to applying the target material to the tube. Thus, the slow sputtering material is located between the tube itself and the target material. This can reduce or eliminate the risk of burn-through during sputtering, particularly in the turn around area, and/or which may increase the target utilization and/or lifetime in certain example instances.

### BACKGROUND OF THE INVENTION

Sputtering is known in the art as a technique for depositing layers or coatings onto substrates. For example, a low-emissivity (low-E) coating can be deposited onto a glass substrate by successively sputter-depositing a plurality of different layers onto the substrate. As an example, a low-E coating may include the following layers in this order: glass substrate/SnO₂/ZnO/Ag/ZnO, where the Ag layer is an IR reflecting layer and the metal oxide layers are dielectric layers. In this example, one or more tin (Sn) targets may be used to sputter-deposit the base layer of SnO₂, one or more zinc (Zn) inclusive targets may be used to sputter-deposit the next layer of ZnO, an Ag target may be used to sputter-deposit the Ag layer, and so forth. The sputtering of each target is performed in a chamber housing a gaseous atmosphere (e.g., a mixture of Ar and O gases in the Sn and/or Zn target atmosphere(s)). In each sputtering chamber, sputtering gas discharge is maintained at a partial pressure less than atmospheric.

Example references discussing sputtering and devices used therefore include U.S. Patent Document Nos. 5,427,665, 5,725,746 and 2004/0163943.

A sputtering target (e.g., cylindrical rotatable magnetron sputtering target) typically includes a cathode tube within which is a magnet array. The cathode tube is often made of stainless steel. The target material is formed on the tube by spraying, casting or pressing it onto the outer surface of the stainless steel cathode tube. Each sputtering chamber includes one or more targets, and thus includes one or more of these cathode tubes. The cathode tube(s) may be held at a negative potential (e.g., -200 to -1500 V), and may be sputtered when rotating. When a target is rotating, ions from the sputtering gas discharge are accelerated into the target and dislodge, or sputter off, atoms of the target material. These atoms, in turn, together with the gas form the appropriate compound (e.g., tin oxide) that is directed to the substrate in order to from a thin film or layer of the same on the substrate.

There are different types of sputtering targets, such as planar magnetron and cylindrical rotatable magnetron targets. Planar magnetrons may have an array of magnets arranged in the form of a closed loop and mounted in a fixed position behind the target. A magnetic field in the formed of a closed loop is thus formed in front of the target. This field causes electrons from the discharge to be trapped in the field and travel in a pattern which creates a more intense ionization and higher sputtering rate. Since sputter is mainly performed in the zone defined by the magnetic field, a racetrack shaped erosion zone is produced as sputtering occurs. In other words, the target material is unevenly sputtered off of the target during sputtering in such planar magnetron targets.

Rotating magnetron targets, including the tube and target material, were developed to overcome erosion problems of planar magnetrons. In the case of rotating magnetrons, the cathode tube and target material thereon are rotated over a magnetic array (that is often stationary) that defines the sputtering zone. Due to the rotation, different portions of the target are continually presented to the sputtering zone which results in more uniform sputtering of the target material off of the tube. While rotating magnetron sputtering targets represent an improvement with respect to erosion, they can still experience uneven or non-uniform erosion of the sputtering material from the tube during sputtering - especially at the high sputtering rate areas proximate the target ends which are sometimes called turn-around areas/portions.

Rotating sputtering targets and target materials are described for instance in documents WO 02/27057 A2 and EP 1 321 537 A1. In WO 02/27057 A2, a backing operatively connected to a sputtering power source and an outer layer of a sputterable material, e.g. a mixture of zinc and a second material, carried by the backing are provided. According to EP 1 321 537 A1, a stainless steel backing holding a target material is used for DC sputtering, wherein an electroconductive carbon felt is arranged between the backing and the target material. The cathode potential required to generate sputtering is provided through a sliding contact point to the backing tube. As target material electroconductive materials such as metals or electroconductive ceramics are used. Also a hollow cylindrical burnt SiC body impregnated with Si is used for DC sputtering, wherein an electroconductive carbon felt is arranged between the backing tube and the SiC body.

US2004/020769 discloses a sputtering target assembly that includes a target bonded to a conductive backing plate. For indicating end of life of the target, the sputter target assembly further includes a sheet of dielectric fibres along an interface between the target and the backing plate.

Unfortunately, the uneven sputtering of the target material off of the cathode tube can result in undesirable burn-through. Burning through the target material to the tube would result in the sputtering of material making up the tube (e.g., stainless steel) thereby resulting in contamination of the sputtered film on the substrate. If allowed to continue, a hole could develop in the backing tube which would allow cooling water from the tube interior to enter the sputtering chamber. Thus, it will be appreciated that burn-through represents a significant problem.

In view of the above, it will be appreciated that there exists a need in the art for a sputtering target constructed in a manner designed to reduce the likelihood of problematic burn-through.

### BRIEF SUMMARY OF EXAMPLES OF THE INVENTION

The present invention consists in sputtering targets as defined in independent claims 1 and 7. Certain example embodiments of this invention relate to a target for use in sputtering materials onto a substrate. In certain example embodiments, the target comprises a cathode tube with a slow sputtering material applied thereto prior to application of the target material to be sputtered onto the substrate. Thus, the slow sputtering material is located between the cathode tube and the material to be sputtered, with both the slow sputtering material and the material to be sputtered being supported by the cathode tube. The use of the slow sputtering material between the cathode tube and the material to be sputtered is advantageous in that this can reduce the risk of bum-through to the tube during sputtering (e.g., in the turn-around area of the target). In certain example embodiments, the use of the slow sputtering material may increase the target utilization and/or lifetime of the target.

The use of a thin layer of slow sputtering material (e.g., Ti) as a precoating for a cathode tube target is capable of preventing or reducing the likeli hood of bum-through to or of the tube. An alternative can be to utilize the slow sputtering material as the material for making the cathode tube. In either case, target materials to be sputtered (e.g., Sn, Zn, etc.) can be applied over the slow sputtering material. When the target material to be sputtered has been consumed by sputtering, especially in the turn-around region of the cathode, the slow sputtering material can protect the target tube from burn-through. In certain example embodiments, the slow sputtering material may extend along the entire, or substantially the entire, length of the target tube, and/or is not exposed during normal sputtering operations.

In certain other example embodiments of this invention, a layer or coating of non-conductive material (e.g., an oxide of Si, Sn, Zn, etc.) provided on the cathode tube 2 (only in the dogbone section) can be used to protect against burn-through. This non-conductive material, located in the dogbone section of the target, is effective in that the etching pattern (sputtering) will slow down or substantially stop at the non-conductive material when the target material in that area is consumed since the surface charge will prevent or reduce sputtering ions such as Ar+ bombardment, especially when a DC, pulse DC or middle frequency AC power supply is used for sputtering. While this could cause an increase in micro-arcing (not big hard arcs) when the non-conductive material is exposed during sputtering, this micro-arcing should not significantly affect coating the product but instead could be advantageous in that it can give an operator a signal or indication as to how much of the target life is left (e.g., it is time to replace the target, or soon will be). The non-conductive layer is applied only in the dogbone section of the target tube.

### BRIEF DESCRIPTION OF THE DRAWINGS

FIGURE 1 is a perspective view of a sputtering target according to an example embodiment of this invention.

FIGURE 2 is a cross sectional view of a part of the sputtering target of Fig. 1.

FIGURE 3 is a perspective view of a sputtering apparatus using the target of Figs. 1-2 (or Fig. 4), according to an example embodiment of this invention.

FIGURE 4 is a perspective view of a sputtering target according to another example embodiment of this invention.

### DETAILED DESCRIPTION OF EXAMPLE EMBODIMENTS OF THE

### INTENTION

Referring now more particularly to the accompanying drawings in which like reference numerals indicate like parts throughout the several views.

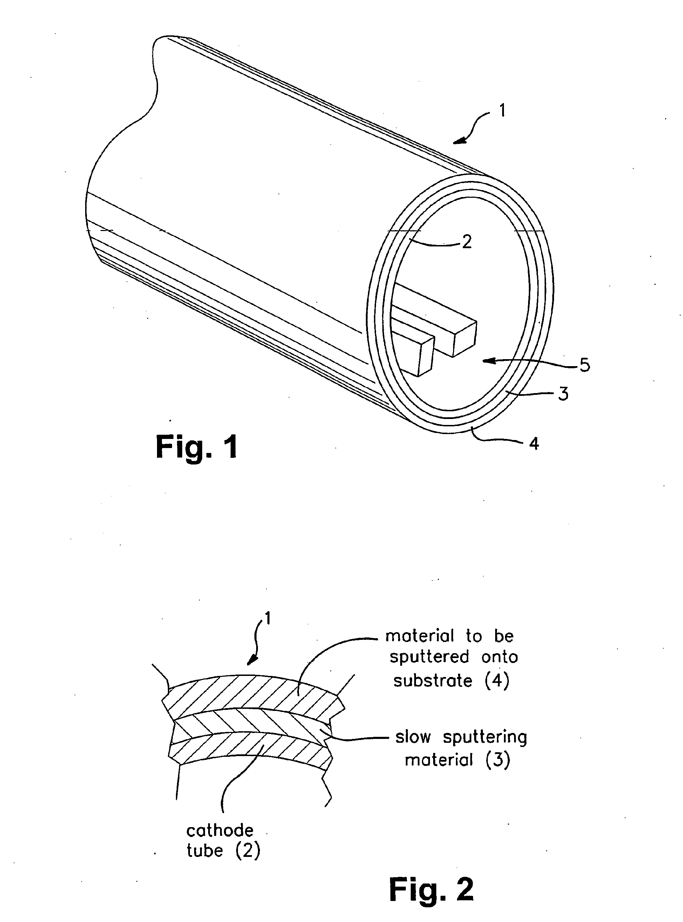

Figs. 1-2 illustrate an example sputtering target according to an example non-limiting embodiment of this invention, with Fig. 2 being a cross-sectional view of a part of the target of Fig. 1. The illustrated cylindrical rotating target 1 includes a cathode tube 2 with a slow sputtering material 3 applied thereto prior to application of the target material 4 to be sputtered onto the substrate. Thus, the slow sputtering material 3 is on the tube 2, and is located between the cathode tube 2 and the target material 4 to be sputtered. Both the slow sputtering material 3 and the material 4 to be sputtered are on and supported by the cathode tube 2. Materials 3 and 4 may be formed on the tube 2 in any suitable manner (e.g., via plasma spraying). The use of the slow sputtering material 3 between the cathode tube 2 and the material 4 to be sputtered is advantageous in that this can reduce the risk of bum-through to, or of, the tube 2 during sputtering (e.g., especially in or near the turn-around area of the target). In certain example embodiments, the target's lifetime and/or utilization may also be increased through the use of the slow sputtering material.

Example slow-sputtering materials that may be used for layer 3 include Ti, W, Nb, Ta, and so forth. Example target materials that may be used for target material layer 4 include, Sn, Zn and the like. In certain example embodiments, the slow sputtering material has both mechanical durability and good adhesion to both the cathode tube and the sputtering/target material. Generally speaking, the material of target material layer 4 has a faster sputtering rate than does the material of layer 3 in certain example embodiments of this invention.

Layers 3 and 4 are both conductive in certain example embodiments of this invention. However, ceramic material may be used for layer 3 and/or layer 4.

The provision of magnet array 5, which is typically stationary even when the tube 2 (and layers 3, 4 thereon) is rotating, inside the tube causes the target material to be sputtered unevenly in certain areas. This can result in burn-through, for example in an area where the sputtering rate of the target material is unusually fast. The provision of material 3 is designed to prevent or reduce the likelihood of such burn-through.

Hollow cathode tubes 2 are generally made of stainless steel. Burning through a target material 4 would sputter material from the backing tube 2, resulting in contamination of the sputtered film being deposited on the substrate. If allowed to continue, a hole could develop in the backing tube 2 which would allow cooling water to enter the chamber; this would damage the product being made and/or sputtering apparatus. Thus, in certain example embodiments, the slow sputter material layer 3 has a thickness of 1-8 mm to provide integrity. The thickness of the target material layer 4 is from 6 to 16 mm.

An alternative is to utilize the slow sputtering material 3 as the material for making the cathode tube. The cathode tube would not be made of stainless steel, but instead would be made of a slow sputter material such as Ti, W, Nb, Ta, or the like. In either case, target materials 4 to be sputtered (e.g., Sn, Zn, etc.) can be applied over the slow sputtering material 3. When the target material 4 to be sputtered has been consumed by sputtering, especially in the turn-around region of the cathode, the slow sputtering material can protect the target tube from burn-through. In certain example embodiments, the slow sputtering material may extend along the entire, or substantially the entire, length of the target tube 2, and/or is not exposed during normal sputtering operations.

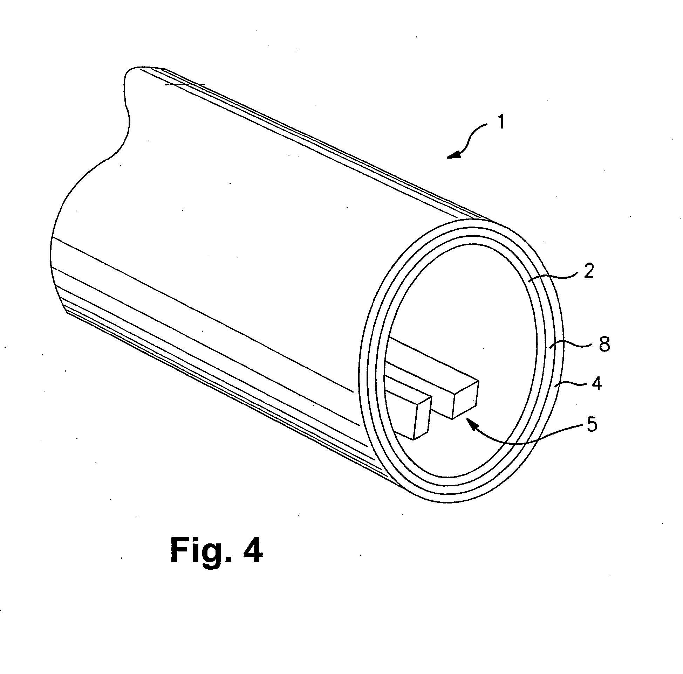

Fig. 4 illustrates a sputtering target according to another example embodiment of this invention. In the Fig. 4 embodiment, a layer or coating 8 of non-conductive material (e.g., an oxide of Si, Sn, Zn, etc.) is provided on the cathode tube 2 only in the dogbone or racetrack section proximate the end(s) of the tube, e- g., when DC, pulse DC or middle frequency AC sputtering is used. In RF spluttering , the dielectric material 8 may be applied to substantially only the dogbone section, or alternatively along the entire tube length since there is no conductivity requirement for the target material. This non-conductive material 8 is provided between the cathode tube 2 and the target material 4, and is used to protect against burn-through. Non-conductive material 8, located in the racetrack or dogbone section of the target near the end(s) thereof, is effective in that the etching pattern (sputtering) will slow down or substantially stop at the non-conductive material 8 when the target material 4 in that area has been consumed (sputtered off ) since the surface charge will prevent or substantially reduce sputtering ion (e.g., Ar+) bombardment. This is also advantageous in that it will reduce contamination of the film being sputtered onto the substrate. While the use of such non-conductive 8 material under a conductive target material could cause an increase in micro-arcing (not big hard arcs) when the non-conductive material is exposed during sputtering, this micro-arcing should not significantly affect coating the product but instead could be advantageous in that it can give an operator a signal or indication as to how much of the target life is left (e.g., it is time to replace the target, or soon will be).

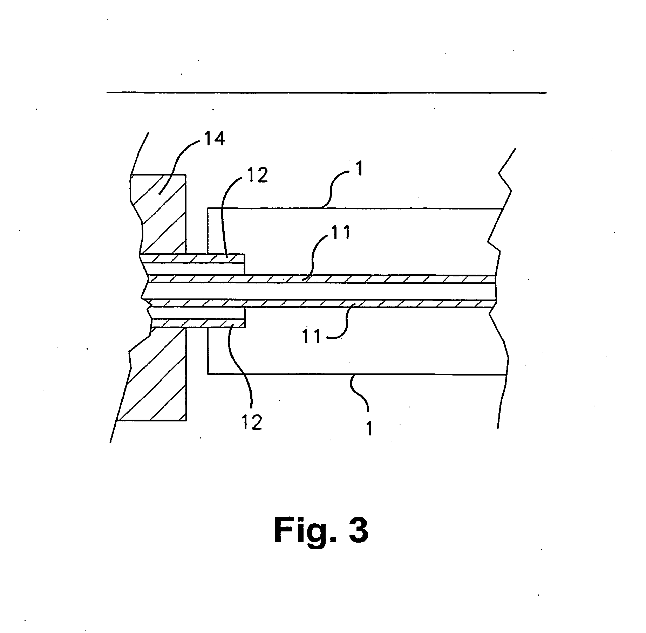

Fig. 3 is a cross sectional view of a sputtering apparatus that can use the target 1 of Figs. 1-2 or 4. The sputtering apparatus includes cooling tubes 11, 12 through which cooling fluid (e.g., water) flows in order to cool the target and/or magnets during sputtering operations. The target 1 is rotatably mounted to support 14 so that during sputtering operations the target 1 rotates relative to the support 14. Shields (not shown) may also be provided in a known manner.

While the invention has been described in connection with what is presently considered to be the most practical and preferred embodiment, it is to be understood that the invention is not to be limited to the disclosed embodiment, but on the contrary, is intended to cover various modifications included within the scope of the appended claims.

## Claims

1. A sputtering target (1) comprising:
a rotatable cathode tube (2) housing at least one magnet therein;
a target material layer (4) comprising one or more of Sn and Zn provided on the outer surface of the cathode tube (2);
a slow sputtering layer (3) which is located between the cathode tube (2) and the target material layer (4) along a portion of the length of the cathode tube for reducing the risk of burn-through to the tube (2);
wherein the slow sputtering layer (3) has a sputter rate less than that of the target material layer (4) for Ar-ions;
**characterized in that** the slow sputtering layer (3) comprises one or more of Ti, W, Nb and Ta.

2. The sputtering target (1) of claim 1, wherein the cathode tube (2) is made of stainless steel.

3. The sputtering target (1) of claim 1, wherein the slow sputtering layer (3) directly contacts each of the cathode tube (2) and the target material layer (4).

4. The sputtering target (1) of claim 1, wherein the slow sputtering layer (3) has a thickness of 1 to 8 mm, and the target material layer (4) has a thickness of 6-16 mm.

5. The sputtering target (1) of claim 1, wherein each of the slow sputtering layer (3) and the target material layer (4) are electrically conductive.

6. The sputtering target (1) of claim 1, wherein one or both of the slow sputtering layer (3) and the target material layer (4) is/are non-conductive.

7. A sputtering target (1) comprising:
a conductive rotatable cathode tube (2) housing at least one magnet (5) therein;
a non-conductive layer (8) provided on the cathode tube (2) along a portion of the length of the cathode tube (2);
a target material layer (4) provided on the outer surface of the cathode tube (2) over at least the non-conductive layer (8),
wherein the non-conductive layer (8) is provided only proximate one or both turn-around regions of the cathode tube (2), and is not provided in a central portion along the length of the cathode tube (2).

8. The sputtering target (1) of claim 7, wherein the non-conductive layer (8) comprises oxide of silicon and/or metal oxide.

9. The sputtering target (1) of claim 7, wherein the non-conductive layer (8) is adapted to allow a surface charge to reduce or prevent sputtering of material from the target in area(s) where the non-conductive layer (8) is present when the target material (4) has been sputtered off of said area(s).

## Patentansprüche

1. Sputtertarget (1), umfassend:
eine rotierbare Kathodenröhre (2), welche wenigstens einen Magneten darin aufnimmt;
eine Target-Materialschicht (4) umfassend Sn und/oder Zn, welche auf der äußeren Oberfläche der Kathodenröhre (2) vorgesehen ist;
eine langsam sputternde Schicht (3), welche zwischen der Kathodenröhre (2) und der Target-Materialschicht (4) entlang eines Abschnitts der Länge der Kathodenröhre (2) zum Reduzieren des Risikos eines Durchbrennens auf die Röhre (2) angeordnet ist;
wobei die langsam sputternde Schicht (3) eine Sputterrate unterhalb derjenigen der Target-Materialschicht (4) für Ar-Ionen aufweist;
**dadurch gekennzeichnet, dass** die langsam sputternde Schicht (3) eines oder mehrere der Materialien Ti, W, Nb und Ta umfasst.

2. Sputtertarget (1) nach Anspruch 1, wobei die Kathodenröhre (2) aus rostfreiem Stahl hergestellt ist.

3. Sputtertarget (1) nach Anspruch 1, wobei die langsam sputternde Schicht (3) sowohl die Kathodenröhre (2) als auch die Target-Materialschicht (4) direkt kontaktiert.

4. Sputtertarget (1) nach Anspruch 1, wobei die langsam sputternde Schicht (3) eine Dicke von 1 - 8 mm aufweist und wobei die Target-Materialschicht (4) eine Dicke von 6 - 16 mm aufweist.

5. Sputtertarget (1) nach Anspruch 1, wobei sowohl die langsam sputternde Schicht (3) als auch die Target-Materialschicht (4) elektrisch leitfähig sind.

6. Sputtertarget (1) nach Anspruch 1, wobei die langsam sputternde Schicht (3) und/oder die Target-Materialschicht (4) nicht leitfähig sind.

7. Sputtertarget (1) umfassend:
eine leitfähige rotierbare Kathodenröhre (2), welche wenigstens einen Magneten (5) darin aufnimmt;
eine nicht leitfähige Schicht (8), welche entlang eines Abschnitts der Länge der Kathodenröhre (2) auf der Kathodenröhre (2) vorgesehen ist;
eine Target-Materialschicht (4) welche auf der äußeren Oberfläche der Kathodenröhre (2) über wenigstens der nicht leitfähigen Schicht (8) vorgesehen ist,
wobei die nicht leitfähige Schicht (8) ausschließlich benachbart zu einer oder beiden Umkehrregionen der Kathodenröhre (2) vorgesehen ist, und nicht in einem zentralen Abschnitt entlang der Länge der Kathodenröhre (2) vorgesehen ist.

8. Sputtertarget (1) nach Anspruch 7, wobei die nicht leitfähige Schicht (8) Siliziumoxid und/oder Metalloxid umfasst.

9. Sputtertarget (1) nach Anspruch 7, wobei die nicht leitfähige Schicht (8) dazu angepasst, einer Oberflächenladung zu erlauben, dass Sputtern von Material von dem Target in einem Bereich (in Bereichen) verhindert oder reduziert wird, in welchen die nicht leitfähige Schicht (8) vorhanden ist, wenn die Targetschicht (4) abgesputtert worden ist von diesem Bereich (diesen Bereichen).

## Revendications

1. Une cible de pulvérisation cathodique (1), comprenant :
un tube cathodique tournant (2) logeant au moins un aimant à l'intérieur ;
une couche de matériau cible (4) comprenant un ou plusieurs d'entre Sn et Zn, formée sur la surface extérieure du tube cathodique (2) ;
une couche de pulvérisation cathodique lente (3) qui est située entre le tube cathodique (2) et la couche de matériau cible (4) le long d'une partie de la longueur du tube cathodique pour réduire le risque de brûlage jusqu'au tube (2) ;
dans laquelle la couche de pulvérisation cathodique lente (3) présente une vitesse de pulvérisation inférieure à celle de la couche de matériau cible (4) pour les ions Ar;
**caractérisée en ce que** la couche de pulvérisation cathodique lente (3) comprend un ou plusieurs d'entre Ti, W, Nb et Ta.

2. La cible de pulvérisation cathodique (1) de la revendication 1, dans laquelle le tube cathodique (2) est réalisé en acier inoxydable.

3. La cible de pulvérisation cathodique (1) de la revendication 1, dans laquelle la couche de pulvérisation cathodique lente (3) vient directement en contact avec chacun d'entre le tube cathodique (2) et la couche de matériau cible (4).

4. La cible de pulvérisation cathodique de la revendication 1, dans laquelle la couche de pulvérisation cathodique lente présente une épaisseur de 1 à 8 mm, et la couche de matériau cible (4) présente une épaisseur de 6 à 16 mm.

5. La cible de pulvérisation cathodique (1) de la revendication 1, dans laquelle chacune d'entre la couche de pulvérisation cathodique lente (3) et la couche de matériau cible (4) est électriquement conductrice.

6. La cible de pulvérisation cathodique (1) de la revendication 1, dans laquelle l'une ou les deux d'entre la couche de pulvérisation cathodique lente (3) et de la couche de matériau cible (4) est non conductrice.

7. Une cible de pulvérisation cathodique (1), comprenant :
un tube cathodique rotatif conducteur (2) logeant au moins un aimant (5) à l'intérieur ;
une couche non conductrice (8) formée sur le tube cathodique (2) le long d'une partie de la longueur du tube cathodique (2) ;
une couche de matériau cible (4) formée sur la surface extérieure du tube cathodique (2) sur au moins la couche non conductrice (8),
dans laquelle la couche non conductrice (8) est formée seulement à proximité de l'une ou des deux régions de retournement du tube cathodique (2), et n'est pas formée dans une partie centrale le long de la longueur du tube cathodique (2).

8. La cible de pulvérisation cathodique (1) de la revendication 7, dans laquelle la couche non conductrice (8) comprend de l'oxyde de silicium et/ou un oxyde métallique.

9. La cible de pulvérisation cathodique (1) de la revendication 7, dans laquelle la couche non conductrice (8) est apte à permettre à une charge de surface de réduire ou empêcher la pulvérisation cathodique de matériau depuis la cible dans une zone ou des zones où la couche non conductrice (8) est présente lorsque le matériau cible (4) a été pulvérisé hors de ladite zone ou desdites zones.
